# FASCICULE DE BREVET EUROPEEN

(11) **EP 2 065 949 B1**
(45) Date de publication et mention de la délivrance du brevet: **05.11.2014**
(21) Numéro de dépôt: 08291106.6
(22) Date de dépôt: 24.11.2008
(51) Int. Cl.: H01L 51/52, H01L 51/56, G02F 1/1333, H01L 27/32

(54) **Procédé de fabrication d'un dispositif d'affichage électronique recouvert d'une plaque de protection**
Verfahren zur Herstellung einer elektronischen Anzeigevorrichtung, die mit einer Schutzplatte abgedeckt ist
Method of manufacturing an electronic display device covered with a protective plate

(30) Priorité: 27.11.2007 FR 0708294
(43) Date de publication de la demande: 03.06.2009
(73) Titulaire: Commissariat à l'Énergie Atomique et aux Énergies Alternatives, 75015 Paris (FR)
(72) Inventeur: Prat, Christophe, 44220 Coueron (FR); Vaufrey, David, 38000 Grenoble (FR)
(74) Mandataire: Bolinches, Michel Jean-Marie

(56) Documents cités:
- JP-A- 2001 126 866
- JP-A- 2004 247 239
- JP-A- 2007 234 332
- US-A1- 2005 258 429
- US-A1- 2006 220 550

## Description

La présente invention concerne un procédé de fabrication d'un dispositif d'affichage électronique, comportant un écran recouvert d'une plaque de protection éventuellement pourvue de filtres optiques colorés destinés à coopérer avec cet écran. L'invention s'applique, d'une manière générale, à des écrans de type couleur ou monochrome et, en particulier, à des dispositifs d'affichage compacts à écran miniature (i.e. à microécran ou « microdisplay » en anglais).

De manière connue, les dispositifs d'affichage à microécran, comme par exemple ceux à diodes électroluminescentes organiques (« OLED » pour « organic light-emitting diode »), comprennent une zone active formée d'une matrice de pixels et une zone de connexion électrique qui est agencée de manière adjacente à cette zone active et qui comprend typiquement un alignement de contacts électriques. Ces dispositifs à microécran sont fabriqués par assemblage de filtres optiques colorés respectivement sur des points de couleur des pixels qui forment la partie active du microécran et qui recouvrent un substrat semi-conducteur typiquement constitué d'une tranche de silicium. Ces filtres sont usuellement déposés sur la face interne d'une plaque de verre que l'on vient coller sur le microécran, de manière à le protéger à la manière d'une encapsulation étanche contre l'humidité et l'oxygène de l'environnement extérieur.

En général, on réalise cet assemblage en appliquant un film de colle réticulable par rayonnement ultraviolet sur toute la surface du microécran ou de la face interne de la plaque de protection équipée des filtres, du fait qu'il est techniquement difficile de circonscrire cette application de colle à la seule zone active du microécran. Or, il résulte de ce collage de la plaque de protection sur le microécran et de la réticulation de la colle par ce rayonnement à travers la plaque ainsi assemblée la présence de colle durcie recouvrant les contacts électriques de la zone de connexion, ce qui complique l'opération ultérieure de « libération » des contacts via le découpage de la plaque au droit de la séparation entre les zones active et de connexion.

Pour résoudre ce problème de la préservation des contacts électriques du microécran ainsi recouvert de la plaque de protection, on a notamment par le passé appliqué cette colle réticulable :
- sous la forme d'un cordon entourant la zone active du microécran comme par exemple décrit dans le document US-B2-6 825 612, avec comme inconvénient en résultant une protection imparfaite du microécran par la plaque, ou
- d'une manière sélective sur cette zone active par sérigraphie, ce qui présente l'inconvénient de requérir un degré de précision élevé dans l'application des points de colle, ou encore
- en pré-structurant la face d'assemblage de la plaque de protection pour y former des cavités destinées à faire face aux contacts électriques et de profondeur très supérieure à l'épaisseur du film de colle appliqué, pour que la colle vienne se loger dans ces cavités, avec comme inconvénient l'étape préalable requise de structuration de la plaque.

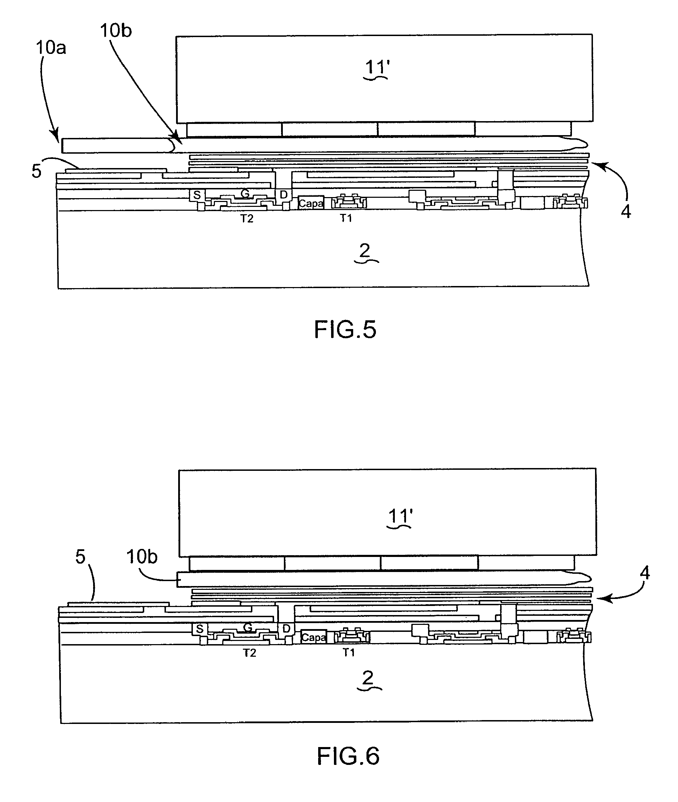

Le document JP-A-2001-126866 présente à sa figure 6 un procédé de fabrication d'un dispositif d'affichage électronique dont l'accessibilité aux connexions électriques est facilité par l'utilisation d'une plaque de protection pourvue entre deux zones actives adjacentes d'un film opaque de masquage du rayonnement de réticulation de la colle solidarisant la plaque avec ces zone actives. Comme visible à la figure 6, la découpe des portions non utiles de la plaque ne s'accompagne pas de la disparition du film opaque, de sorte que cette plaque demeure pourvue d'une partie de ce film.

Le document US-A1-2006/0220550 présente un procédé de dépôt d'une couche hydrophobe antiadhésive sur un substrat ne faisant pas partie de la plaque de protection recouvrant le dispositif, pour éviter que ce substrat n'adhère à une colle le surmontant, sans traiter du problème lié à la réticulation de cette colle entre cette plaque et un écran.

Un but de la présente invention est de proposer un procédé de fabrication d'un dispositif d'affichage électronique qui remédie aux inconvénients précités, ce dispositif comprenant un substrat revêtu sur l'une au moins de ses faces d'un écran, tel qu'un microécran, lequel comprend une zone active formée d'une matrice de pixels et une zone de connexion électrique, l'écran étant solidarisé par l'intermédiaire d'une colle réticulable par un rayonnement électromagnétique avec une plaque de protection qui est perméable à ce rayonnement et qui présente une face d'assemblage avec l'écran, ce procédé comprenant les étapes suivantes :
a) une application de la colle à l'état non réticulé sur la surface de l'écran et/ou de la face d'assemblage de la plaque de protection,
b) une solidarisation par collage de cette face d'assemblage avec l'écran,
c) une émission dudit rayonnement à travers la plaque de protection pour réticuler la colle, puis
d) un enlèvement d'une portion de la plaque de protection recouvrant ladite zone de connexion, en vue de rendre cette dernière accessible électriquement.

A cet effet, le procédé selon l'invention est tel que :
- antérieurement à l'étape a), on dépose une couche de masquage opaque audit rayonnement en un emplacement prédéterminé de la plaque de protection destiné à faire face à ladite zone de connexion suite à l'étape b), pour que cette couche s'oppose lors de l'étape c) à la réticulation de la colle appliquée en regard de ladite zone de connexion et pour que seule la colle appliquée en regard de ladite zone active soit réticulée,
- lors de l'étape d), on retire totalement la couche de masquage de la plaque de protection avec ladite portion de celle-ci enlevée, de sorte que cette plaque soit alors totalement dépourvue de matériau opaque audit rayonnement, et que
- postérieurement à l'étape d), on retire de ladite zone de connexion la colle non réticulée la recouvrant qui n'a pas été enlevée avec ladite portion de la plaque de protection.

Par « dispositif d'affichage électronique », on entend de manière connue dans la présente description tout afficheur par exemple à cristaux liquides (« LCD » ou « liquid crystal display »), à écran à émission par effet de champ (« FED » ou « field-emission display ») ou à écran électroluminescent, à titre non limitatif. Quant à la zone active du ou de chaque écran, elle peut être indifféremment de type à matrice active ou passive.

Avantageusement, le ou chaque écran du dispositif fabriqué par le procédé selon l'invention est un microécran électroluminescent pouvant être de type organique ou inorganique, i.e. incorporant un film organique (respectivement inorganique) entre deux électrodes inférieure et supérieure qui servent respectivement d'anode et de cathode pour le dispositif et dont l'une au moins est transparente à la lumière émise par ce microécran.

A titre encore plus avantageux, le ou chaque écran est un microécran de type « OLED », i.e. à diodes électroluminescentes organiques.

A titre de matériaux utilisables pour réaliser ledit substrat et la plaque de protection, on peut respectivement citer tout matériau semi-conducteur, de préférence le silicium ou le silicium sur verre, et tout matériau perméable audit rayonnement et avantageusement à la lumière émise par l'écran, tel que le verre ou une matière plastique.

Concernant la plaque de protection, elle peut dans le cas particulier d'un écran couleur être pourvue de filtres optiques colorés sur sa face d'assemblage avec l'écran, de telle manière que ces filtres soient appliqués à l'étape b) précitée en regard des points de couleur correspondants de chacun des pixels de l'écran. On notera que l'écran du dispositif selon l'invention pourrait ne pas nécessiter l'adjonction de filtres optiques colorés à cette plaque de protection, laquelle permettrait alors simplement d'encapsuler l'écran.

Selon une autre caractéristique de l'invention, ladite zone de connexion du ou de chaque écran peut être formée par au moins un alignement de connecteurs situé à l'extérieur de ladite zone active et par exemple à proximité d'un bord périphérique de l'écran.

On notera que ce procédé selon l'invention permet une répartition aisée de la colle sur la surface de la plaque de protection ou de l'écran en incluant le recouvrement de toute ou partie de la zone de connexion par cette colle, étant précisé que cette colle se trouve ultérieurement à l'état réticulé par ce rayonnement en regard de la zone active de l'écran, adhérant de ce fait de manière satisfaisante à cette zone active, alors qu'elle demeure au contraire à l'état non réticulé (i.e. fluide avec une viscosité réduite) en regard de la zone de connexion de l'écran du fait de l'interposition de ladite couche de masquage, n'adhérant donc pas aux connecteurs électriques de cet écran.

Avantageusement, l'on peut ainsi appliquer la colle à l'étape a) sensiblement sur toute la surface de ladite zone de connexion de l'écran ou, de préférence, sur toute la surface dudit emplacement prédéterminé de la plaque de protection.

Selon une autre caractéristique avantageusement de l'invention, l'on peut retirer la colle non réticulée (i.e. de viscosité réduite, car non durcie) de ladite zone de connexion par simple dissolution, en utilisant un solvant adapté à cette colle.

La colle utilisée dans ce procédé selon l'invention peut être toute colle réticulable par un rayonnement électromagnétique du domaine visible ou invisible, tel qu'un rayonnement ultraviolet, à titre non limitatif. Cette colle réticulable par un tel rayonnement ultraviolet peut être par exemple une colle de type acrylate ou époxy mono-composant ou bi-composants.

Quant à ladite couche de masquage spécifiquement opaque à ce rayonnement ultraviolet, elle est avantageusement réalisée en un matériau à base de chrome ou d'aluminium.

Egalement avantageusement dans le cas spécifique d'un écran couleur pour lequel la plaque de protection est équipée desdits filtres optiques colorés sur sa face d'assemblage avec cet écran, l'on peut utiliser le même matériau (e.g. à base de chrome ou d'aluminium) pour réaliser tant lesdits filtres optiques colorés que cette couche de masquage.

Encore plus avantageusement, cette couche de masquage opaque aux rayonnements ultraviolets est exclusivement constituée du métal ou de l'alliage de métaux utilisé pour former ces filtres, de préférence le chrome ou l'aluminium. On notera que cette utilisation pour la couche de masquage d'un matériau couramment répandu qui est choisi identique à celui des filtres présente l'avantage de ne pas nécessiter une étape de préparation supplémentaire de cette couche.

De manière générale, on dépose ladite couche de masquage sur la plaque de protection de telle sorte que l'épaisseur de cette couche soit de préférence comprise entre 50 nm et 100 nm.

Avantageusement, ledit emplacement prédéterminé où l'on dépose cette couche de masquage est localisé sur ladite face d'assemblage (i.e. interne à l'état assemblé) de la plaque de protection.

On notera que ce dépôt sur la face interne de la plaque de protection permet de s'affranchir du phénomène de déviation par diffraction du faisceau de rayonnement parvenant au niveau des bords de la couche de masquage, si celle-ci était déposée sur la face externe de la plaque.

Parallèlement à l'étape d), on retire en outre de manière connue une portion dudit substrat s'étendant entre un bord périphérique de ce dernier et un bord latéral de ladite zone de connexion.

D'autres avantages, caractéristiques et détails de l'invention ressortiront du complément de description qui va suivre en référence à des dessins annexés, donnés uniquement à titre d'exemples et dans lesquels :
la figure 1 est une vue de dessus schématique des zones active et de connexion d'un microécran d'un dispositif d'affichage selon l'invention, destiné à être recouvert d'une plaque de protection pourvue de filtres colorés,
la figure 2 est une vue schématique en coupe transversale d'un dispositif d'affichage assemblé par un procédé connu, illustrant l'étape finale de découpage du substrat et de la plaque de protection pour libérer la zone de connexion du microécran,
la figure 3 est une vue schématique éclatée en coupe transversale d'un dispositif d'affichage dont la plaque de protection pourvue de filtres a été traitée selon le procédé de l'invention avant son assemblage par collage sur le microécran,
la figure 4 est une vue schématique en coupe transversale du dispositif de la figure 3 après assemblage de la plaque ainsi traitée sur le microécran, illustrant l'étape de réticulation d'une région seulement de la colle appliquée à l'interface par un rayonnement,
la figure 5 est une vue schématique en coupe transversale du dispositif de la figure 4 suite à cette étape de réticulation, après découpage du substrat et de la plaque selon la figure 2, et
la figure 6 est une vue schématique en coupe transversale du dispositif de la figure 5, suite à l'étape de nettoyage de la zone de connexion du microécran recouverte de la région non réticulée de la colle.

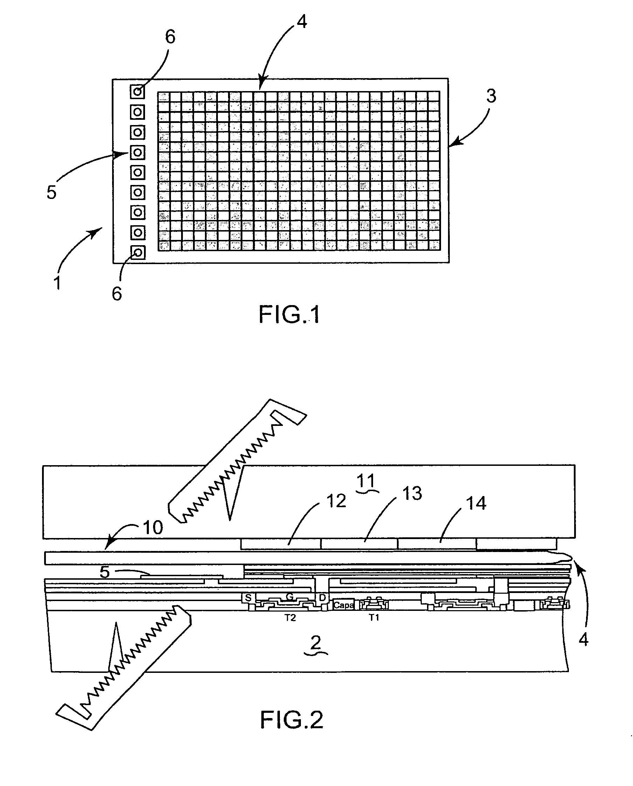

Le dispositif d'affichage électronique en couleur 1 illustré à la figure 1 est dans cet exemple de type « OLED », comprenant de manière connue un substrat 2 typiquement en silicium ou en silicium sur verre (voir figures 2 à 6) revêtu d'un microécran 3 qui comprend une zone active 4 formée d'une matrice de pixels et une zone de connexion électrique 5 extérieure à la zone active 4. La zone active 4 surmonte une structure de circuit intégré représentée de manière symbolique aux figures 2 à 6 par une source S, une grille G, un drain D, deux transistors T1 et T2 et un condensateur « capa ». La zone de connexion 5 est par exemple formée d'un alignement de contacts 6 ou connecteurs électriques pour l'établissement d'une différence de potentiel entre des électrodes 7 et 8 intégrées au microécran 3.

Dans cet exemple de microécran 3 électroluminescent « OLED » illustré aux figures 2 à 6, un film organique 9 (monocouche ou multicouches) est intercalé entre les deux électrodes inférieure 7 et supérieure 8 qui servent respectivement d'anode et de cathode pour le dispositif 1 et dont l'une au moins est transparente à la lumière émise par le microécran 3 afin de faire rayonner la lumière émise vers l'extérieur du dispositif 1. Quant au film organique d'intercalation 9, il est conçu pour transférer les électrons et les trous qui proviennent des électrodes 7 et 8 et qui sont recombinés pour générer des excitons et donc l'émission de lumière.

Egalement de manière connue et comme illustré à la figure 2, le microécran 3 est dans un premier temps solidarisé, par l'intermédiaire d'une colle réticulable 10 par un rayonnement UV, avec une plaque de protection 11 ou capot d'encapsulation typiquement en verre ou en plastique qui est perméable à ce rayonnement et également avantageusement à la lumière émise par le microécran 3 lorsque l'émission se fait à travers cette plaque 11, et qui peut être pourvue de filtres colorés 12, 13 et 14 (rouges, verts et bleus) sur sa face interne 11a d'assemblage avec le microécran 3, de manière que les filtres 12 à 14 soient respectivement appliqués contre les points de couleur de chaque pixel de la zone active 4. Dans un second temps, on procède au découpage, d'une part, du substrat 2 au droit et en dessous du bord externe de la zone de connexion 5 et, d'autre part, de la plaque de protection 11 au droit et au dessus de la ligne de séparation entre la zone active 4 et la zone de connexion 5, pour libérer cette dernière.

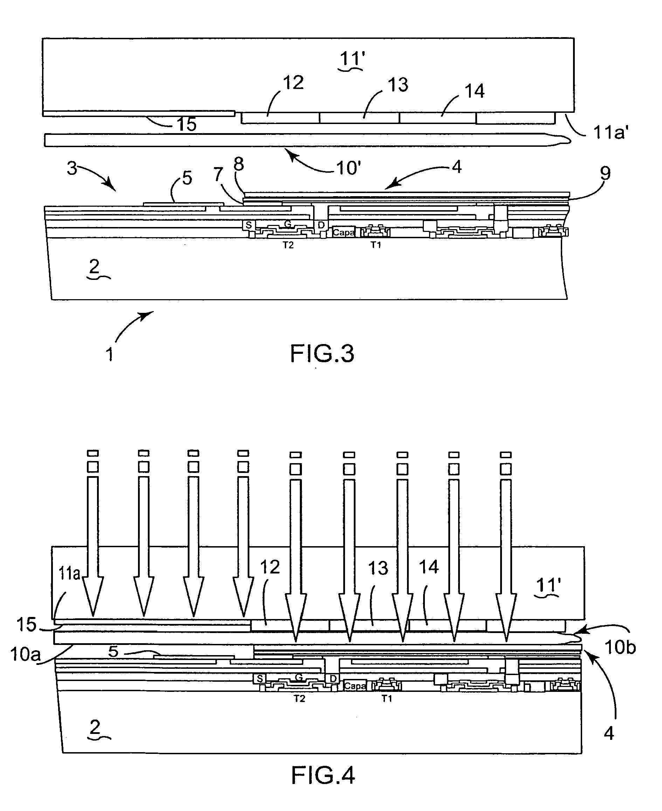

La figure 3 illustre en vue éclatée l'application de la colle 10' à l'état non réticulé sur la totalité de la surface de la face interne 11 a' de la plaque de protection 11' selon l'invention pourvue par exemple des filtres colorés 12 à 14, laquelle face interne 11a' a été préalablement traitée en y déposant une couche de masquage 15 opaque au rayonnement UV en un emplacement prédéterminé de cette face 11a' qui est destiné à faire face à la zone de connexion 5 lors de l'assemblage et qui est adjacent aux filtres 12 à 14 lorsque la plaque de protection 11' en est équipée.

Selon une variante de l'invention, la couche de masquage 15 pourrait être déposée sur la face externe de la plaque 11' opposée à la face interne d'assemblage 11a', en un emplacement de cette face externe également destiné à faire face à la zone de connexion 5 lors de l'assemblage.

A titre de colle réticulable 10' par rayonnement UV pouvant être utilisée dans ce procédé de l'invention, on peut par exemple citer les colles DELO Katiobond 45952 (époxy monocomposant), DELO Photobond 4302 (acrylate monocomposant), Dymax 425 (acrylate monocomposant), Dymax X-516-99-E (acrylate monocomposant), Dymax 628-VLV (acrylate monocomposant), Polytec PI OG146 (époxy monocomposant), Polytec PI OG114-4 (époxy monocomposant), Polytec PI 301-2, parties A et B (époxy bi-composants), Polytec PI 301-2FL, parties A et B (époxy bi-composants), Polytec PI OG142-13 (époxy monocomposant) et Epotecni OAD061 (époxy monocomposant).

Selon une caractéristique particulièrement avantageuse de l'invention, la couche de masquage 15 est constituée d'un matériau constituant les filtres 12 à 14 ou entrant dans leur composition, et cette couche 15 opaque au rayonnement UV est de préférence constituée de chrome ou bien d'aluminium, étant déposée d'une manière générale selon une épaisseur pouvant varier de 50 nm à 100 nm.

Comme illustré à la figure 4, la couche de masquage 15 s'oppose à la transmission en dessous de la plaque 11' du rayonnement UV (symbolisé par les flèches verticales) l'ayant traversée, ce qui a pour effet de ne pas réticuler la région 10a de la colle 10' sous-jacente à cette couche 15 en regard de la zone de connexion 5, alors que ce rayonnement atteint la région 10b de la colle 10' sous-jacente aux filtres 12 à 14 en regard de la zone active 4 et réticule ainsi cette région de colle 10b.

Comme visible à la figure 5, on obtient ainsi grâce au procédé selon l'invention un film de colle 10' divisé en deux régions 10a et 10b respectivement non réticulée (i.e. non durcie, c'est-à-dire à l'état très fluide et n'adhérant pas aux contacts 6 de la zone de connexion 5) et réticulée (i.e. durcie, adhérant de manière satisfaisante à la zone active 4). Puis on procède de manière connue, à l'instar de la figure 2, au découpage de la plaque de protection 11' pour rendre accessible la zone de connexion 5.

Et comme le montre la figure 6, il suffit ensuite de retirer de la zone de connexion 5 par dissolution (en utilisant un solvant adapté à la colle 10') cette région de colle non réticulée 10a la recouvrant n'ayant pas été enlevée avec la portion découpée de la plaque de protection 11'. De cette manière, on est assuré de la libération complète des contacts électriques 6 de la zone de connexion 5, contrairement à l'état antérieur de la technique illustré à la figure 2 où la colle 10 recouvrant ces contacts 6 y adhérait fortement du fait de son état réticulé et était donc susceptible d'entraver le bon fonctionnement du dispositif d'affichage.

## Revendications

1. Procédé de fabrication d'un dispositif d'affichage électronique (1) comprenant un substrat (2) revêtu sur l'une au moins de ses faces d'un écran (3), tel qu'un microécran, lequel comprend une zone active (4) formée d'une matrice de pixels et une zone de connexion électrique (5), l'écran étant solidarisé par l'intermédiaire d'une colle réticulable (10') par un rayonnement électromagnétique avec une plaque de protection (11') qui est perméable à ce rayonnement et qui présente une face d'assemblage (11a') avec l'écran, ce procédé comprenant les étapes suivantes :
a) une application de la colle à l'état non réticulé sur la surface de l'écran et/ou de la face d'assemblage de la plaque de protection, en incluant le recouvrement de toute ou d'une partie de la zone de connexion
b) une solidarisation par collage de cette face d'assemblage avec l'écran,
c) une émission dudit rayonnement à travers la plaque de protection pour réticuler la colle, puis
d) un enlèvement d'une portion de la plaque de protection recouvrant ladite zone de connexion, en vue de rendre cette dernière accessible électriquement,
dans lequel:
- antérieurement à l'étape a), on dépose une couche de masquage (15) opaque au rayonnement en un emplacement prédéterminé de la plaque de protection destiné à faire face à ladite zone de connexion suite à l'étape b), pour que cette couche s'oppose lors de l'étape c) à la réticulation de la colle appliquée en regard de ladite zone de connexion,
**caractérisé en ce que**:
- lors de l'étape d), on retire totalement la couche de masquage de la plaque de protection avec ladite portion de celle-ci enlevée, de sorte que cette plaque soit alors totalement dépourvue de matériau opaque audit rayonnement, et **en ce que**
- postérieurement à l'étape d), on retire de ladite zone de connexion la colle non réticulée (10a) la recouvrant qui n'a pas été enlevée avec ladite portion de la plaque de protection.

2. Procédé selon la revendication 1, **caractérisé en ce que** ledit emplacement prédéterminé où l'on dépose ladite couche de masquage (15) est localisé sur ladite face d'assemblage (11a') de la plaque de protection (11').

3. Procédé selon la revendication 1 ou 2, **caractérisé en ce que** l'on applique la colle (10') à l'étape a) sensiblement sur toute la surface de ladite zone de connexion (5) de l'écran (3) ou dudit emplacement prédéterminé de la plaque de protection (11').

4. Procédé selon une des revendications précédentes, **caractérisé en ce que** l'on retire la colle non réticulée (10a) de ladite zone de connexion (5) par dissolution, en utilisant un solvant adapté à cette colle.

5. Procédé selon une des revendications précédentes, **caractérisé en ce que** ladite zone de connexion (5) est formée par au moins un alignement de connecteurs (6) situé à proximité d'un bord périphérique de l'écran (3).

6. Procédé selon une des revendications précédentes, **caractérisé en ce que** ladite colle (10'), telle qu'une colle de type acrylate ou époxy, est réticulable par un rayonnement ultraviolet, ladite couche de masquage (15) étant choisie opaque à ce rayonnement.

7. Procédé selon une des revendications précédentes, **caractérisé en ce que** ladite plaque de protection est pourvue de filtres optiques colorés (12, 13, 14) sur sa face d'assemblage (11a') avec l'écran, de telle manière que ces filtres soient appliqués à l'étape b) en regard des points de couleur correspondants de chacun desdits pixels.

8. Procédé selon une des revendications précédentes, **caractérisé en ce que** l'on utilise pour réaliser ladite couche de masquage (15) un matériau à base de chrome ou d'aluminium.

9. Procédé selon les revendications 7 et 8, **caractérisé en ce que** l'on utilise ce même matériau à base de chrome ou d'aluminium pour réaliser lesdits filtres optiques colorés (12, 13, 14).

10. Procédé selon une des revendications précédentes, **caractérisé en ce que** l'on dépose ladite couche de masquage (15) suivant une épaisseur comprise entre 50 nm et 100 nm.

11. Procédé selon une des revendications précédentes, **caractérisé en ce que** le ou chaque écran (3) est un microécran électroluminescent.

12. Procédé selon la revendication 11, **caractérisé en ce que** le ou chaque microécran (3) électroluminescent est de type organique, incorporant un film organique (9) entre deux électrodes inférieure (7) et supérieure (8) qui servent respectivement d'anode et de cathode pour le dispositif (1) et dont l'une au moins est transparente à la lumière émise par ce microécran.

13. Procédé selon la revendication 12, **caractérisé en ce que** le ou chaque microécran (3) est un écran à diodes électroluminescentes organiques (« OLED »).

14. Procédé selon une des revendications précédentes, **caractérisé en ce que** ledit substrat (2) est semi-conducteur, de préférence en silicium ou en silicium sur verre, et **en ce que** la plaque de protection (11') est perméable à la lumière émise par l'écran, cette plaque étant par exemple réalisée en verre ou en matière plastique.

## Patentansprüche

1. Vorfahren zur Herstellung einer elektronischen Anzeigevorrichtung (1), umfassend ein Substrat (2), welches auf weinigstens einer seiner Seiten beschichtet ist mit einem Display (3), wie z.B. ein Mikrodisplay, welches eine aus einer Matrix von Pixeln gebildete aktive Zone (4) und eine Zone zur elektrischen Werbindung (5) umfasst, wobei das Display über einen durch eine elektromagnetische Strahlung vernetzbaren Klebstoff (10') an einer Schutzplatte (11') befestigt ist, welche durchlässig für diese Strahlung ist und welche eine Seite zur Zusammenfügung (11a') mit dem Display aufweist, wobei dieses Verfahren die folgenden Schritte umfaßt:
a) Ausbringung des Klebstoff im nicht vernetzten Zustand auf der Oberflache des Display und/oder der Zusammenfügungsseite der Schutzplatte, was die Bedeckung der gesamten ober eines Teils der Verbindungszone beinhaltet,
b) Befestigung durch Kleben dieser Zusammenfügungsseite mit dem Display,
c) eine Abgabe der Strahlung durch die Schutzplatte, um den Klebstoff zu vernetzern, und dann
d) ein Entfernen eines Abschnitts der Schutzplatte, welcher die Verbindungszone bedeckt, mit dem Ziel, die Letztere elektrisch zugänglich zu machen,
wobei:
- vor dem Schritt a) seine für die Strahlung undurchlässige Maskierungsschicht (15) an einer vorbestimmten Postition der Schutzplatte aufgebracht wind, welche dazu bestimmt ist, im Anschluss an den Schritt b) gegenüber der Verbindungszone zu liegen, damit diese Schicht bei des Schritt c) der Vernetzug des gegenüber der Verbindungszone ausgebrachten Klebstoffs entgegenwirkt,
dadurch gekenntzeichnet, dass:
- bei dem Schritt d) die Maskierungsschicht vollständig von der Schutzplatte, mit deren entfernten Abschnitts entfernt wird, sodass diese Platte dann vollständig frei von für die Strahlung undurchlässigem Material ist, und dass
- nach dem Schritt d) von der Verbindungszone der sie bedeckende nicht vernetzte Klebstoff (10a) entfernt wird, welcher nicht mit dem Abschnitt der Schutzplatte entfernt wurde.

2. Vorfahren nach Anspruch 1, **dadurch gekennzeichnet, dass** die vorbestimmte Position, wo die Maskierungsschicht (15) aufgebraucht wird, sich auf der Zusammenfügungsseite (11a') der Schutzplatte (11') befindet.

3. Verfahren nach Anspruch 1 oder 2, dadurch gekennzeichnen, dass der Klebstoff (10') bei dem Schritt a) im Wesentlichen auf der gesamten Oberfläche der Verbindungszone (5) des Displays (3) oder der vorbestimmten Position der Schutzplatte (11') aufgebraucht wird.

4. Verfahren nach einem der vorhergehender Ansprüche, **dadurch gekennzeichnet, dass** der nicht versetzte Klebstoff (10a) durch Lösen von der Verbindungszone (5) entfernt wird, wobei ein an diesen Klebstoff angepasstes Lösungsmittel verwendet wird.

5. Verfahren nach einem der vorhergehende Ansprüche, **dadurch gekennzeichnet, dass** die Verbindungszone (5) gebildet ist durch wenigstens eine Anordnung von Verbindern (6), welche sich in der Nähe zu einem äußeren Rand des Displays (3) befinden.

6. Verfahren nach einem der vorhergehenden Ansprüche, **dadurch gekennzeichnet, dass** der Klebstoff (10'), wie z.B. ein Klebstoff vom Acrylat- ober Epoxy-Typ, durch Ultraviolettstrahlung versetzbar ist, wobei die Maskierungsschicht (15) undurchlässig für diese Strahlung gewährt ist.

7. Verfahren nach einem der vorhergehenden Ansprüche, **dadurch gekennzeichnet, dass** die Schutzplatte mit farbigen optischen Filtern (12, 13, 14) auf ihrer Zusammenfügungsseite (11a') mit dem Display versehen ist, sodass diese Filter bei dem Schritt b) gegenüber von entsprechenden Farbpunkten von jedem der Pixel appliziert werden.

8. Verfahren nach einem der vorhergehenden Ansprüche, **dadurch gekennzeichnet, dass** zum Realisieren der Maskierungsschicht (15) ein Material auf Basis von Chrom oder Aluminum verwendet wird.

9. Verfahren nach den Ansprüchen 7 und 8, **dadurch gekennzeichnet, dass** dieses selbe Material auf Basic von Chrom oder Aluminium verwendet wird, um die farbigen optischen Filter (12, 13, 14) zu realisieren.

10. Verfahren nach einem der vorhergehenden Ansprüche, **dadurch gekennzeichnet, dass** die Maskierungsschicht (15) mit einer Dicke ausgebracht wird, welches zwischen 50 mm und 100 nm enthalten ist.

11. Verfahren nach einem der vorhergehenden Ansprüche, **dadurch gekennzeichnet, dass** das oder jedes Display (3) ein elektrolumineszentes Mikrodisplay ist.

12. Verfahren nach Anspruch 11, dadurch gekenntzeichnet, dass das ober jedes elektrolumineszente Mikrodisplay (3) vom organischen Typ ist, welches eine organische Dünnschicht (9) zwischen zwei, einer unteren (7) und einer oberen (8), Elektroden beeinhaltet, welche als Anode bzw. Kathode für die Vorrichtung (1) dienen und von welchen wenigstens eine transparent für das von diesem Mikrodisplay abgegebene Licht ist.

13. Verfahren nach Anspruch 12, dadurch gekenntzeichnet, dass das ober jedes Mikrodisplay (3) ein Display mit organischen elektrolumineszenten Dioden ("OLED") ist.

14. Verfahren nach einem der vorhergehenden Ansprüche, dadurch gekenntzeichnet, dass das Substrat (2) halbleitend, vorzugsweise aus Silizium oder Silizium auf Glas ist, und dass die Schutzplatte (11') durchlässig für das von dem Display abgegebene Licht ist, wobei diese Platte beispielsweise aus Glas oder aus einem Kunststoffmaterial realisiert ist.

## Claims

1. A process for manufacturing an electronic display device (1) comprising a substrate (2) coated on one at least of its faces with a display (3), such as a microdisplay, which comprises an active zone (4) formed from a pixel matrix and an electrical connection zone (5), the display being attached, by means of an adhesive (10') crosslinkable by electromagnetic radiation, to a protective plate (11') that is permeable to this radiation and that has a face (11a') for assembly with the display, this process comprising the following steps:
a) application of the adhesive in the uncrosslinked state to the surface of the display and/or of the assembly face of the protective plate, including the coverage of all or part of the connection zone;
b) attachment, by bonding, of this assembly face to the display;
c) emission of said radiation through the protective plate in order to crosslink the adhesive; then
d) removal of one portion of the protective plate covering said connection zone, with a view to rendering the latter electrically accessible,
wherein:
- prior to step a), a masking layer (15) that is opaque to the radiation is deposited on a predetermined location of the protective plate intended to face said connection zone following step b), so that this layer opposes during step c) the crosslinking of the adhesive applied opposite said connection zone,
**Characterized in that**:
- During step d), the masking layer is completely removed from the protective plate with said portion of the latter removed, so that this plate is then completely free of material that is opaque to said radiation, and **in that**
- after step d), removed from said connection zone is the uncrosslinked adhesive (10a) covering it, which has not been removed with said portion of the protective plate.

2. The process as claimed in claim 1, **characterized in that** said predetermined location where said masking layer (15) is deposited is located on said assembly face (11a') of the protective plate (11').

3. The process as claimed in claim 1 or 2, **characterized in that** the adhesive (10') is applied in step a) substantially over the entire surface of said connection zone (5) of the display (3) or said predetermined location of the protective plate (111').

4. The process as claimed in one of the preceding claims, **characterized in that** the uncrosslinked adhesive (10a) is removed from said connection zone (5) by dissolving, using a solvent suitable for this adhesive.

5. The process as claimed in one of the preceding claims, **characterized in that** said connection zone (5) is formed by at least one alignment of connectors (6) located in the vicinity of a peripheral edge of the display (3).

6. The process as claimed in one of the preceding claims, **characterized in that** said adhesive (10'), such as an acrylate or epoxy type adhesive, is crosslinkable by ultraviolet radiation, said masking layer (15) being chosen to be opaque to this radiation.

7. The process as claimed in one of the preceding claims, **characterized in that** said protective plate is provided with colored optical filters (12, 13, 14) on its face (11a') for assembly with the display, in such a way that these filters are applied in step b) opposite corresponding color points of each of said pixels.

8. The process as claimed in one of the preceding claims, **characterized in that** a material based on chromium or aluminum is used for producing said masking layer (15).

9. The process as claimed in claims 7 and 8, **characterized in that** this same material based on chromium or aluminum is used for producing said colored optical filters (12, 13, 14).

10. The process as claimed in one of the preceding claims, **characterized in that** said masking layer (15) is deposited in a thickness between 50 nm and 100 nm.

11. The process as claimed in one of the preceding claims, **characterized in that** the or each display (3) is an electroluminescent microdisplay.

12. The process as claimed in claim 11, **characterized in that** the or each electroluminescent microdisplay (3) is of organic type, incorporating an organic film (9) between two lower (7) and upper (8) electrodes that respectively serve as anode and cathode for the device (1) and of which one at least is transparent to the light emitted by this microdisplay.

13. The process as claimed claim 12, **characterized in that** the or each microdisplay (3) is an organic light-emitting diode (OLED) display.

14. The process as claimed in one of the preceding claims, **characterized in that** said substrate (2) is a semiconductor, preferably made of silicon or silicon-on-glass, and **in that** the protective plate (11') is permeable to the light emitted by the display, this plate being, for example, made of glass or plastic.
